(19) Europäisches Patentamt
European Patent Office
Office européen des brevets

(11) **EP 2 530 722 A2**

(12) **EUROPEAN PATENT APPLICATION**

(43) Date of publication:
**05.12.2012 Bulletin 2012/49**

(51) Int Cl.:
*H01L 31/0216* (2006.01)    *H01L 31/048* (2006.01)

(21) Application number: **12169582.9**

(22) Date of filing: **25.05.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **31.05.2011 US 201113149167**<br><br>(71) Applicant: **PrimeStar Solar, Inc**<br>**Arvada, CO 80004 (US)** | (72) Inventor: **Gossman, Robert Dwayne**<br>**Arvada, CO Colorado 80004 (US)**<br><br>(74) Representative: **Picker, Madeline Margaret**<br>**GE International Inc.**<br>**Global Patent Operation - Europe**<br>**15 John Adam Street**<br>**London WC2N 6LU (GB)** |

(54) **Refractive index matching of thin film layers for photovoltaic devices and methods of their manufacture**

(57)     Thin film photovoltaic devices (10) are generally provided. In one embodiment, the device (10) includes a high index layer (11) (e.g., having a refractive index of about 2 or more) on a glass substrate (12) and a low index layer (13) (e.g., having a refractive index of about 1.5 or less) on the high index layer (11). A transparent conductive oxide layer (14) is positioned on the low index layer (13), and a photovoltaic heterojunction (e.g., a cadmium sulfide layer (18) and a cadmium telluride layer (20)) is positioned on the transparent conductive oxide layer (14). In an alternative embodiment, the device (10) can include the low index layer (13) on the glass substrate (12) and the high index layer (11) on the low index layer (13). Methods are also generally provided for manufacturing such thin film photovoltaic devices (10).

**Fig. 1**

**Description**

BACKGROUND OF THE INVENTION

The subject matter disclosed herein relates generally to refractive index matching thin film layers for use in a photovoltaic device, along with their methods of deposition. More particularly, the subject matter disclosed herein relates to refractive index matching thin film layers for use in cadmium telluride thin film photovoltaic devices and their methods of manufacture.

Devices which include films having a thickness on the order of the wavelength of visible light (i.e., about 0.03 $\mu$m to about 1 $\mu$m) can cause interference with the specularly reflected light. This interference may be constructive or destructive, and as such, can cause a net increase or decrease of reflected light from the thin film device. Thin film solar cells are no exception.

Specifically, the "window layer stack," which includes any layers between the glass substrate and the photovoltaic heterojunction, can often add reflection to a device. For example, in a cadmium telluride thin film photovoltaic device, the window layer stack can include the front contact layer (e.g., a TCO layer), a buffer layer, and a cadmium sulfide layer. This reflection can decrease the amount of light reaching the photovoltaic heterojunction, which in turn leads to a decrease in the amount of current collected from the device. Additionally, unintentional color variation from module-to-module due to slight variation of film thickness can create a non-uniform looking array of photovoltaic modules.

Thus, a need exists for photovoltaic devices having reduced amounts of reflection loss in the window layer stack.

BRIEF DESCRIPTION OF THE INVENTION

Aspects and advantages of the invention will be set forth in part in the following description, or may be obvious from the description, or may be learned through practice of the invention.

Thin film photovoltaic devices are generally provided. In one embodiment, the device includes a high index layer (e.g., having a refractive index of about 2 or more) on a glass substrate and a low index layer (e.g., having a refractive index of about 1.5 or less) on the high index layer. A transparent conductive oxide layer is positioned on the low index layer, and a photovoltaic heterojunction (e.g., a cadmium sulfide layer and a cadmium telluride layer) is positioned on the transparent conductive oxide layer. In an alternative embodiment, the device can include the low index layer on the glass substrate and the high index layer on the low index layer.

Methods are also generally provided for manufacturing such thin film photovoltaic devices. For example, the device can be manufactured via forming a high index layer on a glass superstrate and forming a low index layer on the high index layer. A transparent conductive oxide layer can then be formed on the low index layer, and a photovoltaic heterojunction formed on the transparent conductive oxide layer.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

BRIEF DESCRIPTION OF THE DRAWINGS

A full and enabling disclosure of the present invention, including the best mode thereof, directed to one of ordinary skill in the art, is set forth in the specification, which makes reference to the appended figures, in which:

Fig. 1 shows a general schematic of a cross-sectional view of an example cadmium telluride thin film photovoltaic device including a pair of index matching layers;

Fig. 2 shows a general schematic of a cross-sectional view of another example cadmium telluride thin film photovoltaic device including two pair of index matching layers;

Fig. 3 shows a general schematic of a cross-sectional view of an alternative example cadmium telluride thin film photovoltaic device including a pair of index matching layers;

Fig. 4 shows a general schematic of a cross-sectional view of an alternative example cadmium telluride thin film photovoltaic device including two pair of index matching layers;

Fig. 5 shows a flow diagram of an example method of manufacturing a thin film photovoltaic device;

Fig. 6 shows a flow diagram of another example method of manufacturing a thin film photovoltaic device; and,

Fig. 7 shows a graph comparing the reflectance (%) of the different examples as a function of wavelengths (nm).

Repeat use of reference characters in the present specification and drawings is intended to represent the same or analogous features or elements.

DETAILED DESCRIPTION OF EMBODIMENTS OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers, unless expressly stated to the contrary. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "$\mu$m").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

In general, thin film photovoltaic devices are presently disclosed having at least one pair of index matching layers on the front glass substrate, along with methods of their manufacture. The index matching layers can help reduce reflective loss of light entering the device. Thus, the index matching layers can minimize the amount of reflective losses, leading to maximizing the amount of current that can be generated from the device. Additionally, the index matching layers can generally even out color variations seen on the glass face of the photovoltaic module during use. The index matching layers may also further serve as diffusion barriers for contaminants coming from or through the glass substrate into the underlying thin film layers.

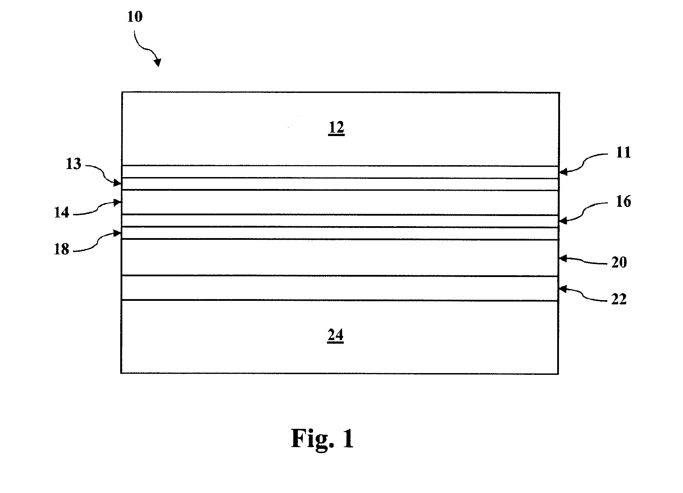

Fig. 1 represents an example cadmium telluride thin film photovoltaic device 10 having a high index layer 11 and a low index layer 13 (forming a pair of index matching layers) positioned between the glass substrate 12 and the transparent conductive oxide (TCO) layer 14. A photovoltaic heterojunction is on the TCO layer 14, shown on the optional RTB layer 16, formed from the cadmium sulfide layer 18 and the cadmium telluride layer 20. Although shown and described as a cadmium telluride thin film photovoltaic device 10, the index matching layers (i.e., the high index layer 11 and a low index layer 13) can be included in any type of photovoltaic device. In the embodiment shown, the TCO layer 14, a resistant transparent buffer (RTB) layer 16, and a cadmium sulfide layer 18 form the window layers of the device 10 between the glass substrate 12 and the cadmium telluride layer 20. Each of these layers is discussed below in greater detail.

The refractive index (sometimes referred to as the index of refraction) of a substance is a measure of the speed of light in that substance, expressed as a ratio of the speed of light in vacuum relative to that in the considered medium. A simple mathematical description of the refractive index (n) is as follows:

$$n = \text{velocity of light in a vacuum / velocity of light in medium.}$$

As light exits the medium, it may also change its propagation direction in proportion to the refractive index (see Snell's law). By measuring the angle of incidence and angle of refraction of the light beam, the refractive index (n) can be determined. The refractive index of materials varies with the frequency of radiated light, resulting in a slightly different refractive index for each color. Unless otherwise stated, the values of refractive indices are calculated at a wavelength of 632 nanometers (nm). Such calculations are routinely performed in the art and methods of conducting them are readily known. One typical method of measuring these films is through the use of ellipsometry or spectroscopic ellipsometry (both techniques may include the use of multiple angles of incident light). For both techniques, the change in phase and polarization of a reference beam of light may be used to fit a model from which can be extracted the refractive index of the material.

In most embodiments, the TCO layer 14 can have a refractive index of about 1.8 to about 2.2 (e.g., about 1.9 to about 2), as can the RTB layer 16, depending on the materials used to form these layers. The cadmium sulfide layer 18 can have a refractive index of about 2.3 to about 2.5 (e.g., about 2.4), and the cadmium telluride layer 20 can have a refractive index of about 2.9 to about 3.1 (e.g., about 3.0). The glass substrate 12 can have a refractive index of about 1.4 to about 1.6 (e.g., about 1.5).

The high index layer 11 generally has a refractive index of about 2.0 or greater (e.g., about 2.0 to about 2.5). In certain embodiments, the high index layer 11 can have a refractive index of about 2.05 to about 2.4, such as about 2.1 to about 2.3. In certain embodiments, the high index layer 11 can be a thin film layer including, but not limited to, titanium dioxide ($TiO_2$), tin oxide, zinc oxide, zinc tin oxide (ZTO), indium oxide ($In_2O_3$), hafnium oxide ($HfO_2$), tantalum pentoxide ($Ta_2O_5$), niobium oxide ($Nb_2O_5$), zirconium oxide ($ZrO_2$), yttrium oxide ($Y_2O_3$), ytterbium oxide ($Yb_2O_3$), silicon nitride ($Si_3N_4$), aluminum nitride (AlN), or mixtures thereof. Other materials may also be included in the high index layer 11, such as dopants, impurities, etc.

The low index layer 13 generally has a refractive index of about 1.5 or less (e.g., about 1.1 to about 1.5). In certain embodiments, the low index layer 13 can have a refractive index of about 1.15 to about 1.4, such as about 1.1 to about 1.3. In certain embodiments, the low index layer 13 can be a thin film layer including, but not limited to, silicon dioxide ($SiO_2$), magnesium fluoride ($MgF_2$), lithium fluoride (LiF), calcium fluoride ($CaF_2$), sodium fluoride (NaF), other group I or group II fluorides, or mixtures thereof. Other materials may also be included in the low index layer 13, such as dopants, impurities, etc.

The thicknesses of the high index layer 11 and the low index layer 13 can be varied according to the materials in the layers 11, 13 and the components of the window film stack. In most embodiments, the thickness of each of the high index layer 11 and the low index layer 13 can be about 5 nm to about 60 nm (e.g., about 10 nm to about 50 nm). In one particular embodiment, the high index layer 11 can be a titanium oxide layer having a thickness of about 10 nm to about 15 nm (e.g., about 11 nm to about 12 nm, such as about 11.5 nm), and the low index layer 13 can be a silicon dioxide layer having a thickness of about 30 nm to about 33 nm (e.g., about 31 nm to about 32 nm, such as about 31.5 nm). In an alternative embodiment, the high index layer 11 can be a ZTO layer having a thickness of about 20 nm to about 27 nm (e.g., about 22 nm to about 26 nm), and the low index layer 13 can be a silicon dioxide layer having a thickness of about 20 nm to about 30 nm (e.g., about 26 nm to about 28 nm, such as about 27 nm).

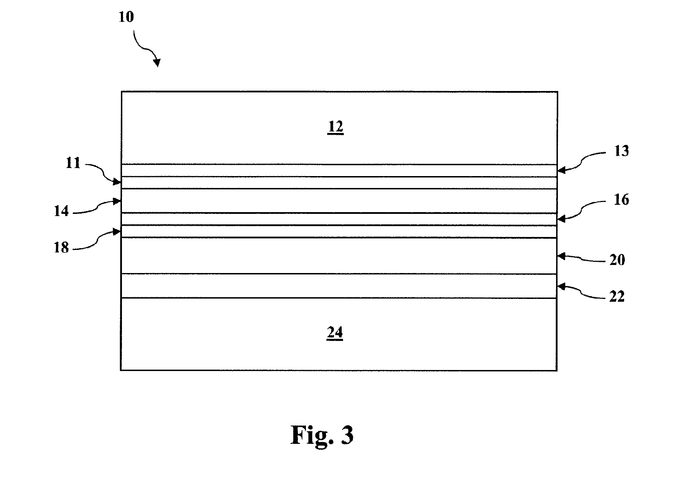

Although shown with the high index layer 11 adjacent to and directly on the glass substrate 12 followed by the low index layer 13 adjacent to and directly on the high index layer 11, other configurations may be utilized. For example, in the alternative embodiment shown in Fig. 3, the low index layer 13 is adjacent to and directly on the glass substrate 12 followed by the high index layer 11 being adjacent to and directly on the low index layer 13.

In the embodiment shown in Figs. 1 and 3, the TCO layer 14 is directly on the pair of index matching layers 11, 13. Specifically, in the embodiment of Fig. 1, the TCO layer 14 is directly on and adjacent to the low index layer 13. Alternatively, in the embodiment of Fig. 3, the TCO layer 14 is directly on and adjacent to the high index layer 11. However, in other embodiments, additional layers may be present between the pair of index matching layers 11, 13 and the TCO layer 14. For example, multiple high index layers and low index layers can be present between the pair of index matching layers 11, 13 and the TCO layer 14, arranged such that the high indexing layers and low indexing layers are in alternating orientation.

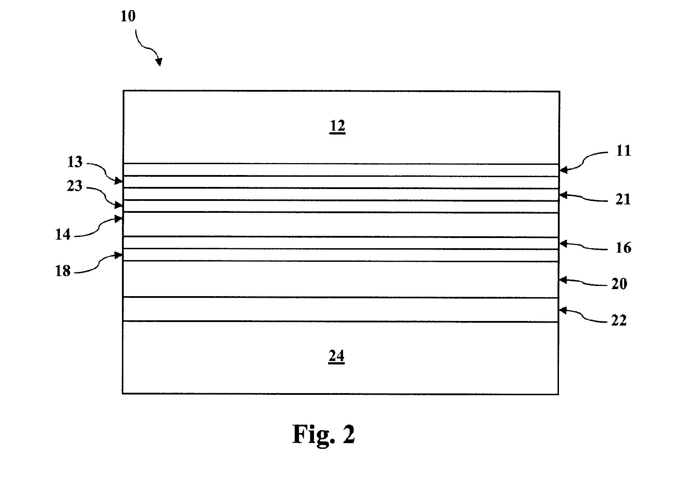

For example, Fig. 2 shows an embodiment similar to that shown in Fig. 1, with the device 10 further including a second pair of index matching layers (i.e., the second high index layer 21 and the second low index layer 23) between the first pair of index matching layers 11, 13 and the TCO layer 14. As show, the second high index layer 21 is directly on and adjacent to the first low indexing layer 13, and the second low index layer 23 is directly on and adjacent to the second high index layer 21, such that the index layer alternate (from the glass substrate 12 to the TCO layer 14) high, low, high, low. In the embodiment shown, the TCO layer 14 is directly on the second low index layer 23. However, in certain embodiments, other layers may be present therebetween.

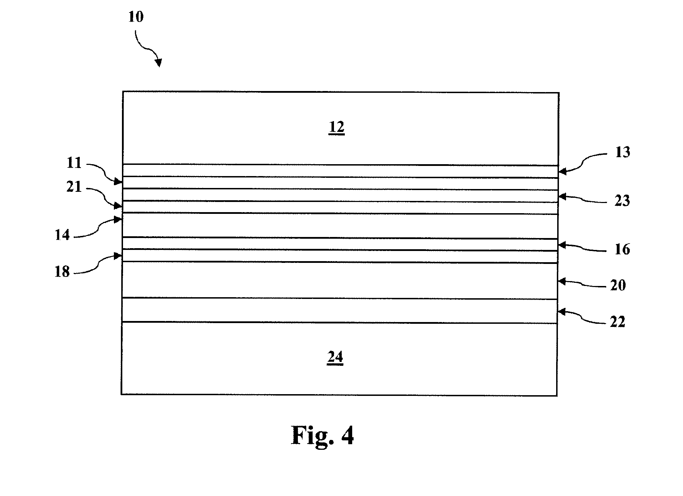

Likewise, Fig. 4 shows an embodiment similar to that shown in Fig. 3, with the device 10 further including a second pair of index matching layers 21, 23 between the first pair of index matching layers 11, 13 and the TCO layer 14. As show, the second low index layer 23 is directly on and adjacent to the first high indexing layer 11, and the second high index layer 21 is directly on and adjacent to the second low index layer 23, such that the index layer alternate (from the glass substrate 12 to the TCO layer 14) low, high, low, high. In the embodiment shown, the TCO layer 14 is directly on the second high index layer 21. However, in certain embodiments, other layers may be present therebetween.

As stated, the example devices 10 of Figs. 1-4 include a top sheet of glass substrate 12 employed as the substrate. In these embodiments, the glass substrate 12 can be referred to as a "superstrate", as it is the substrate on which the subsequent layers are formed even though it faces upward to the radiation source (e.g., the sun) when the photovoltaic device 10 is in used. The top sheet of glass substrate 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass substrate 12 can be a low iron float glass containing less than about 0.15% by weight iron (Fe), and may have a transmissiveness of about 0.9 or greater in the spectrum of interest (e.g., wavelengths from about 300 nm to about 900 nm).

The TCO layer 14 is shown on the glass substrate 12 of the example device 10. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, indium tin oxide, zinc stannate, cadmium stannate, or mixtures thereof. Additionally, the TCO layer 14 can include other conductive, transparent materials. The TCO layer 14 can also include dopants (e.g., fluorine, tin, etc.) and other materials, as desired.

The TCO layer 14 can be formed by sputtering, chemical vapor deposition, spray pyrolysis, or any other suitable deposition method. In one particular embodiment, the TCO layer 14 can be formed by sputtering (e.g., DC sputtering or RF sputtering) on the glass substrate 12. For example, a cadmium stannate layer can be formed by sputtering a hot-pressed target containing stoichiometric amounts of $SnO_2$ and CdO onto the glass substrate 12 in a ratio of about 1 to about 2. The cadmium stannate can alternatively be prepared by using cadmium acetate and tin (II) chloride precursors by spray pyrolysis. In certain embodiments, the TCO layer 14 can have a thickness between about 0.1 $\mu$m and about 1 $\mu$m, for example from about 0.1 $\mu$m to about 0.5 $\mu$m, such as from about 0.25 $\mu$m to about 0.35 $\mu$m.

A resistive transparent buffer layer 16 (RTB layer) is shown on the TCO layer 14 on the example photovoltaic devices 10. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.5 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 20. Thus, it is believed that the RTB layer 16 allows for improved adhesion and/or interaction between the TCO layer 14 and the cadmium telluride layer 20, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide ($SnO_2$), which can be referred to as a zinc tin oxide layer ("ZTO"). In one particular embodiment, the RTB layer 16 can include more tin oxide than zinc oxide. For example, the RTB layer 16 can have a composition with a stoichiometric ratio of $ZnO/SnO_2$ between about 0.25 and about 3, such as in about an one to two (1:2) stoichiometric ratio of tin oxide to zinc oxide. The RTB layer 16 can be formed by sputtering, chemical vapor deposition, spray-pyrolysis, or any other suitable deposition method. In one particular embodiment, the RTB layer 16 can be formed by sputtering (e.g., DC sputtering or RF sputtering) on the TCO layer 14. For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., $O_2$ gas). When the oxidizing atmosphere includes oxygen gas (i.e., $O_2$), the atmosphere can be greater than about 95% pure oxygen, such as greater than about 99%.

In certain embodiments, the RTB layer 16 can have a thickness between about 0.075 $\mu$m and about 1 $\mu$m, for example from about 0.1 $\mu$m to about 0.5 $\mu$m. In particular embodiments, the RTB layer 16 can have a thickness between about 0.08 $\mu$m and about 0.2 $\mu$m, for example from about 0.1 $\mu$m to about 0.15 $\mu$m.

A cadmium sulfide layer 18 is shown on RTB layer 16 of the example device 10. The cadmium sulfide layer 18 is a n-type layer that generally includes cadmium sulfide (CdS) but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., direct current (DC) sputtering or radio frequency (RF) sputtering) on the RTB layer 16. Sputtering deposition generally involves ejecting material from a target, which is the material source, and depositing the ejected material onto the substrate to form the film. DC sputtering generally involves applying a current to a metal target (i.e.,

the cathode) positioned near the substrate (i.e., the anode) within a sputtering chamber to form a direct-current discharge. The sputtering chamber can have a reactive atmosphere (e.g., an oxygen atmosphere, nitrogen atmosphere, fluorine atmosphere) that forms a plasma field between the metal target and the substrate. The pressure of the reactive atmosphere can be between about 1 mTorr and about 20 mTorr for magnetron sputtering. When metal atoms are released from the target upon application of the voltage, the metal atoms can react with the plasma and deposit onto the surface of the substrate. For example, when the atmosphere contains oxygen, the metal atoms released from the metal target can form a metallic oxide layer on the substrate. The current applied to the source material can vary depending on the size of the source material, size of the sputtering chamber, amount of surface area of substrate, and other variables. In some embodiments, the current applied can be from about 2 amps to about 20 amps. Conversely, RF sputtering generally involves exciting a capacitive discharge by applying an alternating-current (AC) or radiofrequency (RF) signal between the target (e.g., a ceramic source material) and the substrate. The sputtering chamber can have an inert atmosphere (e.g., an argon atmosphere) having a pressure between about 1 mTorr and about 20 mTorr.

Due to the presence of the RTB layer 16, the cadmium sulfide layer 18 can have a thickness that is less than about 0.1 $\mu$m, such as between about 10 nm and about 100 nm, such as from about 50 nm to about 80 nm, with a minimal presence of pinholes between the TCO layer 14 and the cadmium sulfide layer 18. Additionally, a cadmium sulfide layer 18 having a thickness less than about 0.1 $\mu$m reduces any absorption of radiation energy by the cadmium sulfide layer 18, effectively increasing the amount of radiation energy reaching the underlying cadmium telluride layer 20.

A cadmium telluride layer 20 is shown on the cadmium sulfide layer 18 in the example devices 10. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the adsorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 $\mu$m and about 10 $\mu$m, such as from about 1 $\mu$m and about 5 $\mu$m. In one particular embodiment, the cadmium telluride layer 20 can have a thickness between about 1.5 $\mu$m and about 4 $\mu$m, such as about 2 $\mu$m to about 3 $\mu$m.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 425° C) for a sufficient time (e.g., from about 1 to about 40 minutes) to create a quality p-type layer of cadmium telluride. Without wishing to be bound by theory, it is believed that annealing the cadmium telluride layer 20 (and the device 10) decreases the deep-defect density and makes the CdTe layer more p-type. Additionally, the cadmium telluride layer 20 can recrystallize and undergo grain regrowth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, $CdTeO_3$, $CdTe_2O_5$, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride ($Cu_2Te$) between the cadmium telluride layer 20 and the back contact layer 22 and/or can create a Cu-doped CdTe layer. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 250° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, silver, or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 $\mu$m to about 10 $\mu$m in thickness, for example from about 1 $\mu$m to about 5 $\mu$m. A metal layer of the back contact, if used for or as part of the back contact layer 22, can be from about 0.1 $\mu$m to about 1.5 $\mu$m in thickness.

The encapsulating glass 24 is also shown in the example cadmium telluride thin film photovoltaic device 10 of Fig. 1.

Other components (not shown) can be included in the example device 10, such as buss bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

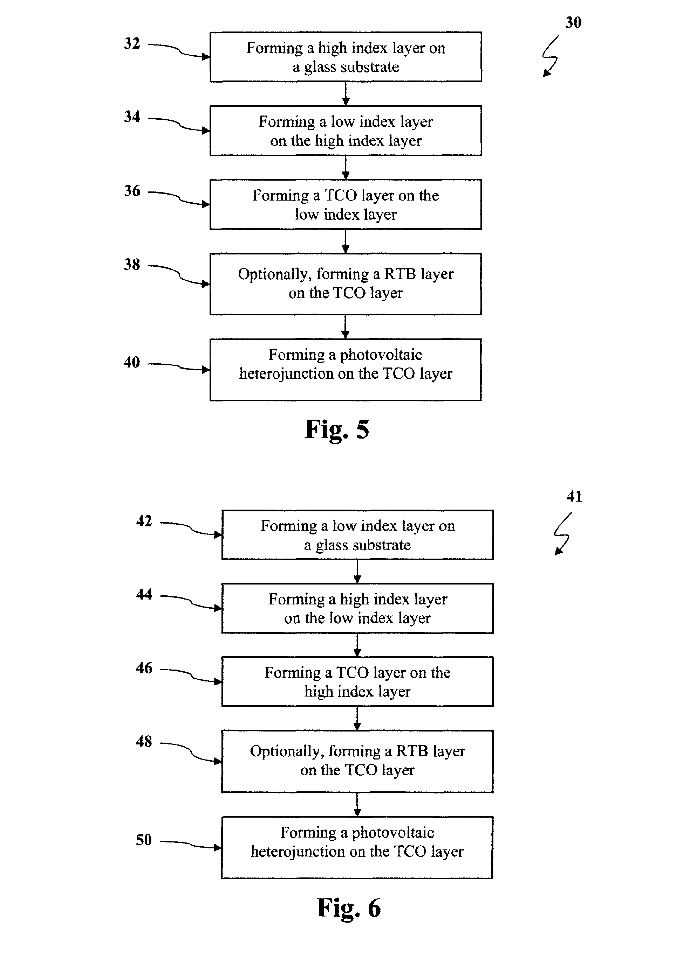

Fig. 5 shows a flow diagram of an example method 30 of manufacturing a photovoltaic device according to one embodiment of the present invention. According to the example method 30, a high index layer (e.g., having a refractive index of about 2 or more) is formed on a glass superstrate at 32, and a low index layer (e.g., having a refractive index of about 1.5 or less) is formed on the high index layer at 34. A TCO layer is formed on a low index layer at 38. At 38, a RTB layer is optionally formed on the TCO layer. A photovoltaic heterojunction is formed on the TCO layer (e.g., on the RTB layer, when present) at 40.

Fig. 6 shows a flow diagram of an alternate method 41 of manufacturing a photovoltaic device according to one embodiment of the present invention. According to the example method 41, a low index layer (e.g., having a refractive index of about 1.5 or less) is formed on a glass superstrate at 42, and a high index layer (e.g., having a refractive index of about 2.0 or more) is formed on the low index layer at 34. A TCO layer is formed on a high index layer at 38. At 38, a RTB layer is optionally formed on the TCO layer. A photovoltaic heterojunction is formed on the TCO layer (e.g., on the RTB layer, when present) at 40.

In one particular embodiment, the photovoltaic heterojunction includes a cadmium sulfide layer is formed on the TCO layer and a cadmium telluride layer formed on the cadmium sulfide layer.

One of ordinary skill in the art should recognize that other processing and/or treatments can be included in the method 30. For instance, when including a cadmium sulfide layer and a cadmium telluride layer, the cadmium telluride layer can be annealed in the presence of cadmium chloride, washed to remove any CdO formed on the surface, and doped with copper. Back contact layer(s) can be applied over the cadmium telluride layer, and an encapsulating glass can be applied over the back contact layer. Additionally, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

EXAMPLE

Models were assembled using software commercially available under the name TFCalc from Software Spectra, Inc. (Portland, OR). Unless otherwise stated, each Example included a TCO layer of cadmium stannate that was about 365 nm thick. A RTB layer of zinc tin oxide (ZTO) that was about 60 nm thick was on the TCO layer. A cadmium sulfide layer having a thickness of about 50 nm was on the RTB layer. A cadmium telluride layer was on the cadmium sulfide layer.

Various combinations of index matching layers were included to minimize the reflectance variation of the model. Example 1 included no index matching layers (i.e., the TCO layer was directly on the glass) for a comparative example. Example 2 included a high index layer of titanium oxide having a thickness of about 11.5 nm on the glass, followed by a low index layer of silicon dioxide having a thickness of about 31.5 nm on the high index layer. Example 3 included a high index layer of ZTO having a thickness of about 20.7 nm on the glass, and a low index layer of silicon dioxide having a thickness of about 26.9 nm on the high index layer. Example 4 included 4 layers (or two high index/low index pairs). Starting from the glass, the first layer included ZTO and had a thickness of about 14.2 nm, followed by a second layer including $SiO_2$ having a thickness of about 52.1 nm, followed by a third layer including ZTO having a thickness of about 36.5 nm, and followed by a fourth layer including $SiO_2$ having a thickness of about 23.1 nm.

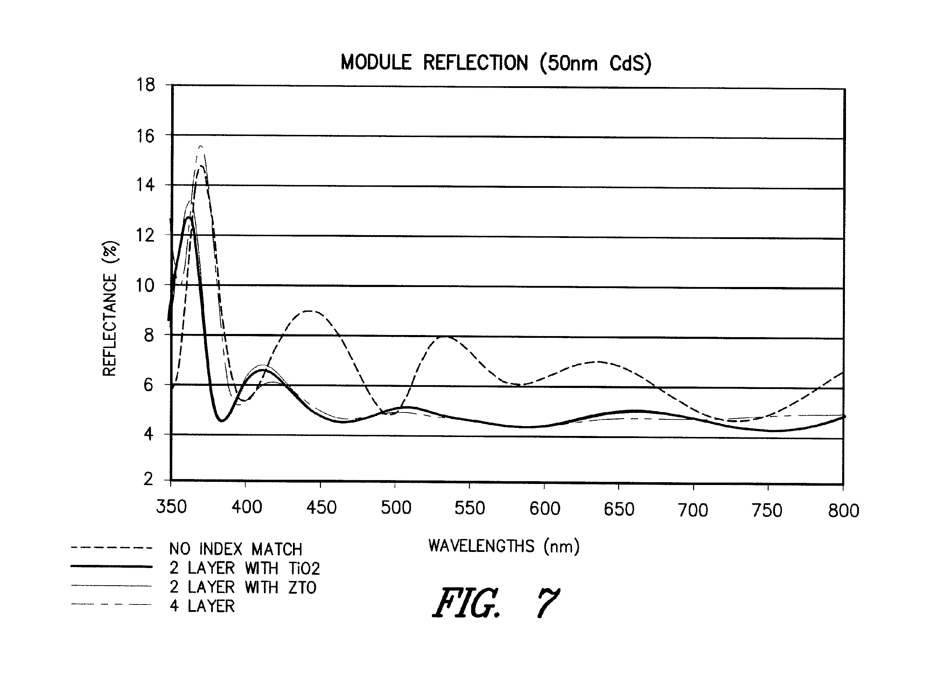

Fig. 7 compares the reflectance (%) of the different models at different wavelengths (nm) of the visible spectrum (i.e., 350 nm to 800 nm). From these results, it is apparent that the film stack without any index matching layers (i.e., Example 1) generates an additional 2-4% reflection across the spectrum (between 400 nm and 800 nm).

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

**Claims**

1.   A thin film photovoltaic device (10), comprising:

   a glass substrate (12);
   a high index layer (11) on the glass substrate (12), wherein the high index layer (11) has a refractive index of about 2 or more;
   a low index layer (13) on the high index layer (11), wherein the low index layer (13) has a refractive index of about 1.5 or less;
   a transparent conductive oxide layer (14) on the low index layer (13); and,
   a photovoltaic heterojunction on the transparent conductive oxide layer (14).

2.   The device of claim 1, wherein the high index layer (11) has a refractive index of about 2 to about 2.5, and/or wherein the low index layer (13) has a refractive index of about 1.1 to about 1.5.

3.   The device of claim 1 or claim 2, wherein the high index layer (11) comprises titanium dioxide, tin oxide, zinc oxide, zinc tin oxide, indium oxide, hafnium oxide, tantalum pentoxide, niobium oxide, zirconium oxide, yttrium oxide, ytterbium oxide, silicon nitride, aluminum nitride, or mixtures thereof.

4.   The device of claim 1, 2 or 3, wherein the low index layer(13) comprises silicon dioxide, magnesium fluoride, lithium fluoride, calcium fluoride, sodium fluoride, other group I or group II fluorides, or mixtures thereof.

5.   The device of any one of claims 1 to 4, wherein the transparent conductive oxide layer (14) is directly on the low index layer (13).

6.   The device of any one of claims 1 to 5, further comprising:

   a second high index layer (21) on the low index layer (13), wherein the second high index layer (21) has a refractive index of about 2 or more; and,
   a second low index layer (23) on the second high index layer (21) such that the transparent conductive oxide layer (14)is on the second low index layer (23), wherein the second low index layer (23) has a refractive index of about 1.5 or less.

**7.** The device of claim 6, wherein the second high index layer (21) has a refractive index of about 2 to about 2.5, and wherein the second low index layer (23) has a refractive index of about 1.1 to about 1.5.

**8.** The device of claim 6 or claim 7, wherein the transparent conductive oxide layer (14) is directly on the second low index layer (23).

**9.** The device of any one of claims 1 to 8, wherein the photovoltaic heterojunction comprises a cadmium sulfide layer (18) on the transparent conductive oxide layer (14) and a cadmium telluride layer (20) on the cadmium sulfide layer (18).

**10.** The device of any one of claims 1 to 9, wherein the high index layer (11) comprises titanium oxide and has a thickness of about 10 nm to about 15 nm, and wherein the low index layer (13) comprises silicon dioxide and has a thickness of about 30 nm to about 33 nm.

**11.** The device of any one of claims 1 to 10, wherein the high index layer (11) comprises a zinc tin oxide and has a thickness of about 20 nm to about 27 nm, and wherein the low index layer (13) comprises silicon dioxide and has a thickness of about 20 nm to about 30 nm.

**12.** The device of any one of claims 1 to 11, further comprising:

a resistive transparent buffer layer positioned between the transparent conductive oxide layer (14) and the photovoltaic heterojunction.

**13.** A thin film photovoltaic device (10), comprising:

a glass substrate (20);
a low index layer (13) on the glass substrate (12), wherein the low index layer (13) has a refractive index of about 1.5 or less;
a high index layer (11) on the low index layer (13), wherein the high index layer (11) has a refractive index of about 2 or more;
a transparent conductive oxide layer (14) on the low index layer (13); and,
a photovoltaic heterojunction on the transparent conductive oxide layer (14).

**14.** A method for manufacturing a thin film photovoltaic device (10), the method comprising:

forming a high index layer (11) on a glass superstrate (12), wherein the high index layer (11) has a refractive index of about 2 or more;
forming a low index layer (13) on the glass superstrate (12), wherein the low index layer (13) has a refractive index of about 1.5 or less;
forming a transparent conductive oxide layer (14) on the low index layer (13);
and,
forming a photovoltaic heterojunction on the transparent conductive oxide layer (14).

**15.** The method of claim 13, wherein the high index layer (11) comprises titanium dioxide, tin oxide, zinc oxide, zinc tin oxide, indium oxide, hafnium oxide, tantalum pentoxide, niobium oxide, zirconium oxide, yttrium oxide, ytterbium oxide, silicon nitride, aluminum nitride, or mixtures thereof, and/or the low index layer(13) comprises silicon dioxide, magnesium fluoride, lithium fluoride, calcium fluoride, sodium fluoride, other group I or group II fluorides, or mixtures thereof.

10

**Fig. 1**

10

12

13

23

14

18

11

21

16

20

22

24

**Fig. 2**

**Fig. 3**

10

12

11

21

14

18

13

23

16

20

22

24

**Fig. 4**

32 → Forming a high index layer on a glass substrate

34 → Forming a low index layer on the high index layer

36 → Forming a TCO layer on the low index layer

38 → Optionally, forming a RTB layer on the TCO layer

40 → Forming a photovoltaic heterojunction on the TCO layer

30

**Fig. 5**

42 → Forming a low index layer on a glass substrate

44 → Forming a high index layer on the low index layer

46 → Forming a TCO layer on the high index layer

48 → Optionally, forming a RTB layer on the TCO layer

50 → Forming a photovoltaic heterojunction on the TCO layer

41

**Fig. 6**

MODULE REFLECTION (50nm CdS)

FIG. 7

NO INDEX MATCH
2 LAYER WITH TiO2
2 LAYER WITH ZTO
4 LAYER